# EUROPEAN PATENT APPLICATION

(11) **EP 4 216 270 A1**
(43) Date of publication of application: **26.07.2023**
(21) Application number: 22854404.5
(22) Date of filing: 09.09.2022
(51) Int. Cl.: H01L 23/488, H01L 21/60

(54) **CHIP STRUCTURE, MANUFACTURING METHOD FOR CHIP STRUCTURE, AND ELECTRONIC DEVICE**

(30) Priority: 08.12.2021 CN 202111490490
(71) Applicant: Honor Device Co., Ltd., Shenzhen, Guangdong 518040 (CN)
(72) Inventor: HUO, Yuan, Shenzhen, Guangdong 518040 (CN)
(74) Representative: Isarpatent
(86) International application number: PCT/CN2022/118045
(87) International publication number: WO 2023/103497

(57) **Abstract**

Embodiments of this application provide a chip structure, a method for manufacturing a chip structure, and an electronic device. The chip structure includes: a circuit board, where there are a plurality of pads on the circuit board, and the plurality of pads include a plurality of first pads and at least one second pad; a chip, where the chip is electrically connected to the first pad, and the second pad is a redundant pad; a plurality of electrical connection structures, where the plurality of electrical connection structures include a plurality of first electrical connection structures and at least one second electrical connection structure, the first electrical connection structure is located on a surface of the first pad, and electrically connects the chip and the first pad, and the second electrical connection structure is located on a surface of the second pad; and a packaging layer, where the packaging layer fills a gap between the circuit board and the chip. In the chip structure, reliability of a solder joint between the chip and the circuit board can be improved.

## Description

This application claims priority to Chinese Patent Application No. 202111490490.4, filed with the China National Intellectual Property Administration on December 8, 2021 and entitled "CHIP STRUCTURE, METHOD FOR MANUFACTURING CHIP STRUCTURE, AND ELECTRONIC DEVICE", which is incorporated herein by reference in its entirety.

### TECHNICAL FIELD

This application relates to the field of chip packaging technologies, and in particular, to a chip structure, a method for manufacturing a chip structure, and an electronic device that includes the chip structure.

### BACKGROUND

With the development of electronic technologies, an integrated circuit board has increasingly high assembly density, there is an increasingly small solder joint in a microelectronic device, and there is an increasingly high requirement for reliability. In a packaging technology widely used in electronic packaging, for example, wafer-level chip scale packaging (Wafer Level Chip Scale Package, WLCSP) or flip chip scale packaging (Flip Chip Scale Package, FCCSP), an electronic device and a substrate or a circuit board are directly electrically and mechanically connected by using a solder joint. The flip chip packaging technology is a technology in which a bare chip faces down and a solder ball on the bare chip is soldered to a pad on a circuit board by using solder paste. As increasingly more signals are integrated on the chip, how to improve reliability of a solder joint between the chip and the circuit board becomes a research hotspot of a person skilled in the art.

### SUMMARY

This application provides a chip structure, a method for manufacturing a chip structure, and an electronic device that includes the chip structure, to improve reliability of a solder joint between a chip and a circuit board.

To achieve the foregoing objective, this application provides the following technical solutions.

According to a first aspect, an embodiment of this application provides a chip structure, including:
a circuit board, where there are a plurality of pads on the circuit board, and the plurality of pads include a plurality of first pads and at least one second pad;
a chip, where the chip is electrically connected to the first pad, and the second pad is a redundant pad;
a plurality of electrical connection structures, where the plurality of electrical connection structures include a plurality of first electrical connection structures and at least one second electrical connection structure, the first electrical connection structure is located on a surface of the first pad, and electrically connects the chip and the first pad, and the second electrical connection structure is located on a surface of the second pad; and
a packaging layer, where the packaging layer fills a gap between the circuit board and the chip.

In the chip structure provided in this embodiment of this application, the second pad is added to the circuit board, to increase pad density of the circuit board, so as to reduce a spacing between adjacent pads on the circuit board, and the second electrical connection structure is disposed on the second pad, to reduce a gap between the second pad and the chip. In this way, when glue is dispensed in the gap between the chip and the circuit board to form the packaging layer, capillary action between the adjacent pads on the circuit board is enhanced, to improve a glue filling effect between the chip and the circuit board, increase bonding force between the circuit board and the chip, reduce a probability that a glue filling void occurs, and resolve a problem that a solder joint dendrite occurs.

In an implementation, in a direction from the circuit board to the chip, a ratio of a height of the second electrical connection structure to a distance between the second pad and the chip ranges from 0.5 to 1 (inclusive). In this way, when glue is dispensed to fill the gap between the chip and the circuit board to form the packaging layer, there is relatively strong capillary action at a position at which the second pad is located.

In still another implementation, on a plane on which the circuit board is located, a size of a gap between adjacent pads in the plurality of pads is not greater than 400 microns. In this way, when glue is dispensed to fill the gap between the chip and the circuit board to form the packaging layer, there is relatively strong capillary action at a position at which each pad is located, to improve a glue filling effect of the gap between the chip and the circuit board.

In yet another implementation, the plurality of pads are evenly distributed on the circuit board, so that there is same or similar capillary action at positions at which all the pads are located. In this way, when glue is dispensed to fill the gap between the chip and the circuit board, there is a same or similar speed at which positions at which all the pads are located are wetted by the glue, to further reduce the probability that a glue filling void occurs.

According to a second aspect, an embodiment of this application provides a method for manufacturing a chip structure. The method includes:
placing a stencil on a side surface that is of a circuit board and on which there is a pad, where there are a plurality of pads on the circuit board, the plurality of pads include a plurality of first pads and at least one second pad, the stencil is provided with a plurality of openings, the plurality of openings include a plurality of first openings and at least one second opening, the first openings are in a one-to-one correspondence with the first pads, to expose the first pads, and the second opening is in a one-to-one correspondence with the second pad, to expose the second pad;
printing solder paste in each opening of the stencil, and removing the stencil;
placing a chip on a side that is of the solder paste and that is far away from the circuit board, where there are a plurality of solder balls on the chip, and the solder balls on the chip are in a one-to-one correspondence with the first pads;
heating the solder paste to form a plurality of electrical connection structures, where the plurality of electrical connection structures include a plurality of first electrical connection structures and at least one second electrical connection structure, the first electrical connection structure is a structure formed after solder paste located on a surface of the first pad and the solder ball on the chip are heated and melted, and the second electrical connection structure is a structure formed after solder paste located on a surface of the second pad is heated and melted; and
dispensing glue in a gap between the chip and the circuit board to form a packaging layer between the chip and the circuit board.

In the method for manufacturing a chip structure provided in this embodiment of this application, the second pad is added to the circuit board, to increase pad density of the circuit board, so as to reduce a spacing between adjacent pads on the circuit board, and the second electrical connection structure is disposed on the second pad, to reduce a gap between the second pad and the chip. In this way, when glue is dispensed in the gap between the chip and the circuit board to form the packaging layer, capillary action between the adjacent pads on the circuit board is enhanced, to improve a glue filling effect between the chip and the circuit board, increase bonding force between the circuit board and the chip, reduce a probability that a glue filling void occurs, and resolve a problem that a solder joint dendrite occurs.

In an implementation, sizes of the first opening and the second opening are the same, so that in a direction from the circuit board to the chip, a height of the first electrical connection structure located on the surface of the first pad is the same as a height of the second electrical connection structure located on the surface of the second pad.

In another implementation, a size of the second opening is greater than a size of the first opening, so that after the solder paste is heated, in a direction from the circuit board to the chip, a height of the second electrical connection structure located on the surface of the second pad is greater than a height of the first electrical connection structure located on the surface of the first pad, to further reduce a gap between the second electrical connection structure and the chip. In this way, when glue is dispensed in the gap between the chip and the circuit board, capillary action between adjacent pads located in a fourth region is enhanced, to improve the glue filling effect between the chip and the circuit board, increase the bonding force between the circuit board and the chip, reduce the probability that a glue filling void occurs, and resolve the problem that a solder joint dendrite occurs.

In still another implementation, the second opening is 1-3 (inclusive) times a size of the first opening, so that solder paste located in the second opening is 1-3 (inclusive) times a size of solder paste located in the first opening, to ensure that a height of the second connection structure is not less than a height of the first connection structure, and does not exceed a height of the gap between the second pad and the chip.

According to a third aspect, an embodiment of this application provides an electronic device. The electronic device includes the chip structure described in any one of the foregoing aspects and the implementations, to improve reliability of a solder joint between a chip and a circuit board in the chip structure.

### BRIEF DESCRIPTION OF DRAWINGS

FIG. 1 is a schematic diagram of an application scenario of an electronic device to which a chip structure is applied;
FIG. 2 is a schematic diagram of a structure of an existing chip structure;
FIG. 3 to FIG. 5 are schematic diagrams of some structures in a process of manufacturing an existing chip structure;
FIG. 6 is a schematic diagram of layout of solder balls on a chip in an existing chip structure;
FIG. 7 is a schematic diagram of layout of pads on a circuit board electrically connected to the chip in FIG. 6;
FIG. 8 is a schematic diagram of a flow direction of glue that exists when the glue is dispensed in a gap between a chip and a circuit board in a process of manufacturing an existing chip structure;
FIG. 9 is a schematic diagram of a glue filling void formed after glue dispensing in a gap between a chip and a circuit board is completed in a process of manufacturing an existing chip structure;
FIG. 10 is a schematic diagram of layout of pads on a circuit board in a chip structure according to an embodiment of this application;
FIG. 11 is a schematic diagram of layout of solder balls on a chip soldered to the circuit board shown in FIG. 10;
FIG. 12 is a schematic diagram of a structure of a chip structure according to an embodiment of this application;
FIG. 13 is a schematic diagram of a structure that exists before solder paste is melted in a process of manufacturing a chip structure according to an embodiment of this application;
FIG. 14 is a flowchart of a method for manufacturing a chip structure according to an embodiment of this application;
FIG. 15 to FIG. 22 are schematic diagrams of structures in method steps in a method for manufacturing a chip structure according to an embodiment of this application; and
FIG. 23 is a schematic diagram of a structure of an electronic device according to an embodiment of this application.

### DESCRIPTION OF EMBODIMENTS

The following clearly and completely describes the technical solutions in the embodiments of this application with reference to the accompanying drawings in the embodiments of this application. The terms used in the following embodiments are merely used for describing specific embodiments, and are not intended to limit this application. The singular forms "one", "a", "the", "the foregoing", "this", and "the one" used in this specification and the appended claims of this application are also intended to include forms such as "one or more", unless otherwise clearly specified in the context. It may be further understood that in the embodiments of this application, "one or more" means one, two, or more. "And/Or" is an association relationship for describing associated objects, and represents that three relationships may exist. For example, "A and/or B" may represent the following cases: Only A exists, both A and B exist, and only B exists, where A and B may be in singular forms or plural forms. The character "/" usually indicates an "or" relationship between associated objects.

In this specification, the description such as reference to "an embodiment" or "some embodiments" means that specific features, structures, or characteristics described with reference to the embodiment are included in one or more embodiments of this application. Therefore, the statements "in an embodiment", "in some embodiments", "in some other embodiments", and the like appearing at different positions in this specification do not necessarily refer to a same embodiment, but mean "one or more but not all embodiments", unless otherwise specifically emphasized in another manner. The terms "include", "comprise", "have", and variants thereof mean "include but is not limited to", unless otherwise specifically emphasized in another manner.

"A plurality of" in the embodiments of this application means "greater than or equal to two". It should be noted that in the description of the embodiments of this application, words such as "first" and "second" are merely used for distinguishing between description, and cannot be understood as an indication or implication of relative importance, or cannot be understood as an indication or implication of a sequence.

To describe the following embodiments clearly and briefly, related technologies are first briefly described.

PCB (Printed Circuit Board) is also referred to as a printed circuit board, is an important electronic component, is a support of an electronic device, and is a carrier for electrically connecting electronic devices.

A land is a basic unit for surface mount assembly, and is used to form a land pattern (land pattern) of a circuit board.

A chip is a general term for semiconductor component products, is a form used to miniaturize a circuit (mainly including a semiconductor device and further including a passive component and the like) in electronics, and is often manufactured on a surface of a semiconductor wafer.

A flip chip (Flip chip) is a leadless structure, usually includes a circuit unit, and is designed to be electrically and mechanically connected to a circuit by using an appropriate quantity of solder balls (covered with conductive adhesive) on a surface of the flip chip.

A solder joint is an electrical connection structure formed after a solder ball on a chip and solder paste on a surface of a pad on a circuit board are melted.

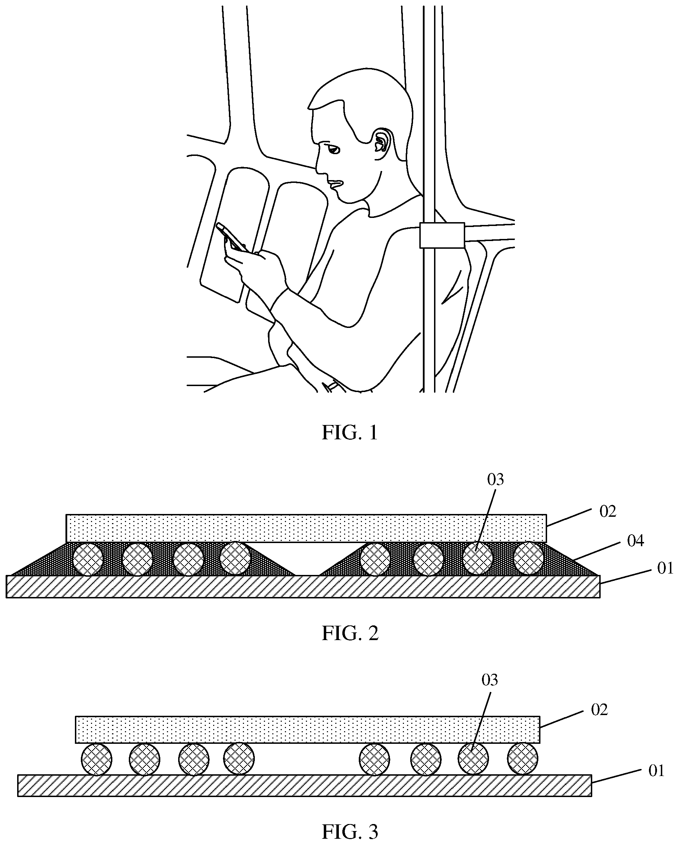

FIG. 1 is a schematic diagram of a scenario in which a chip structure is applied to an electronic device. In daily life or work, a user often uses the electronic device to perform activities such as making an entertainment, doing office work, or learning. However, in an actual use process, there is sometimes a phenomenon in which the chip structure is short-circuited and consequently the electronic device cannot be turned on.

FIG. 2 is a schematic diagram of a structure of a flip chip structure. In flip chip packaging in the conventional technology, a solder ball on a surface of a chip 02 is usually first soldered to a pad on a circuit board 01 by using solder paste, and then a gap between the chip 02 and the circuit board 01 is filled by using an underfill (underfill) technology, to form filling adhesive 04 in the gap between the chip 02 and the circuit board, so as to implement packaging of the gap between the chip and the circuit board, increase bonding force between the chip 02 and the circuit board 01 by using the filling adhesive 04, and improve reliability of a solder joint formed after the chip 02 is soldered to the pad on the circuit board 01 by using the solder paste.

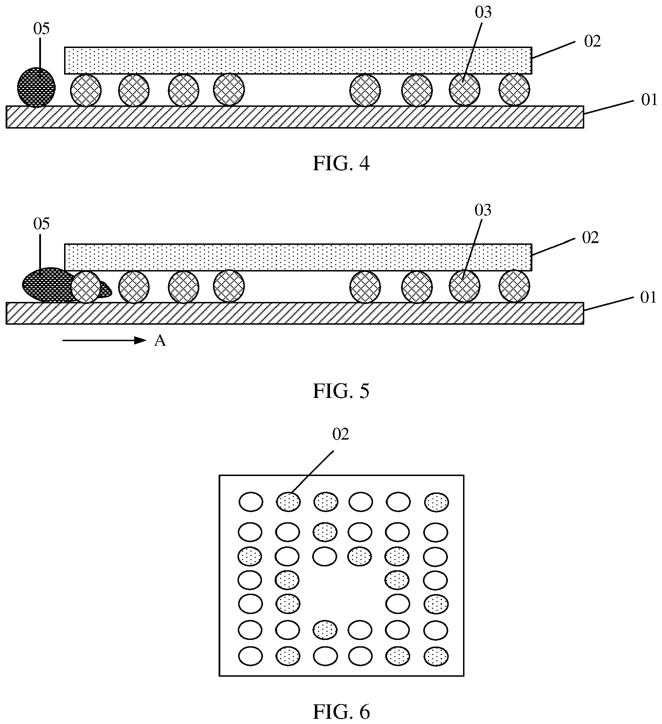

Specifically, when the gap between the chip and the circuit board is filled by using the underfill technology, the solder ball on the chip 02 is first soldered to the pad on the circuit board 01 by using the solder paste, to form the solder joint, as shown in FIG. 3. Then, glue 05 is dispensed on one side of the gap between the chip 02 and the circuit board 01, as shown in FIG. 4. In this way, under capillary action, the glue 05 flows in a direction A from an edge of the gap between the chip 02 and the circuit board 01 to a central region of the gap between the chip 02 and the circuit board 01, as shown in FIG. 5. Packaging of the solder joint between the chip 02 and the circuit board 01 is completed when flow ends. A smaller gap between adjacent solder joints in the gap between the circuit board and the chip indicates stronger capillary action, and a higher degree to which the gap between the adjacent solder joints is filled with glue indicates higher reliability of the solder joints.

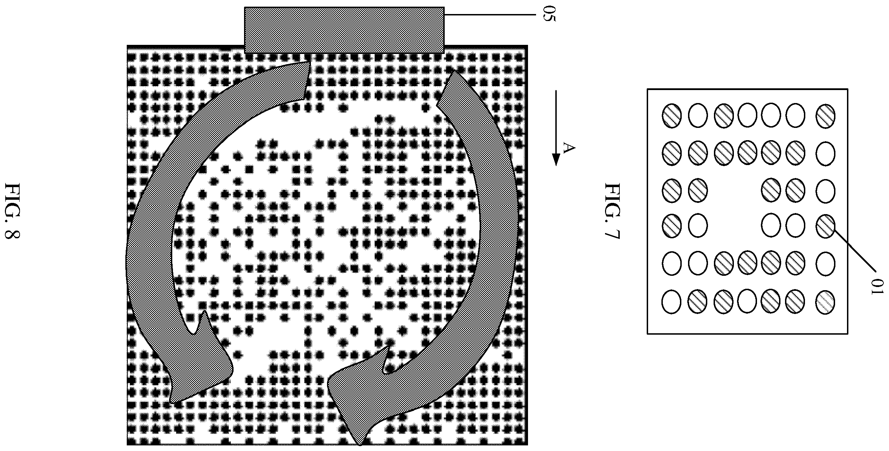

As shown in FIG. 6 and FIG. 7, currently, layout of pads on the circuit board 01 is the same as layout of solder balls on the chip 02 soldered to the circuit board 01, and the pads on the circuit board 01 are in a one-to-one correspondence with the solder balls on the chip 02. The layout of the solder balls on the chip 02 is related to an actual application scenario requirement of the chip. There is usually a case in which there is relatively high solder ball density in some regions and relatively low solder ball density in some regions. Therefore, there is a phenomenon in which there is relatively high pad density in some regions and relatively low pad density in some regions in the layout of the pads on the circuit board.

In the layout of the pads on the circuit board, in a region in which there is high pad density, there is a relatively small gap between adjacent pads, and correspondingly, after a solder joint is subsequently formed, there is relatively strong capillary action between adjacent solder joints, and a gap between the adjacent solder joints is better filled with glue; and in a region in which there is low pad density, there is a relatively large gap between adjacent pads, and correspondingly, there is relatively weak capillary action between adjacent solder joints that are subsequently formed, and a gap between the adjacent solder joints is filled with glue at a lower speed, and even cannot be wetted.

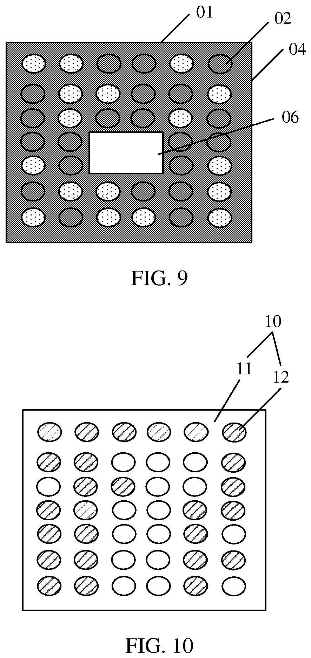

Still as shown in FIG. 6, in the layout of the solder balls on the chip, there is usually relatively high density on an edge and relatively low density in a central region. Therefore, when glue is filled between the circuit board and the chip, there is relatively strong capillary action in an edge region and the edge region is wetted at a relatively high speed, and there is relatively weak capillary action in the central region and the central region is wetted at a relatively low speed. As shown in FIG. 8, when all regions around the gap between the circuit board and the chip are filled with glue, but a central region is not filled with glue, air in the central region between the circuit board and the chip cannot be discharged, and a glue filling void is formed, as shown in a region 06 shown in FIG. 9. Consequently, reliability of a solder joint in this region is affected.

In addition, when overall environmental testing (for example, double 85 environmental testing, namely, environmental testing in which a temperature parameter is 85 and a humidity parameter is 85) is performed on a chip structure that includes the circuit board and the chip, a solder joint dendrite is likely to occur in a region in which the glue filling void is located, resulting in a short circuit between adjacent solder joints and the like. Consequently, the chip structure that includes the circuit board and the chip cannot work normally.

In view of this, an embodiment of this application provides a chip structure. As shown in FIG. 10 to FIG. 12, the chip structure includes a circuit board 10, a chip 20, a plurality of electrical connection structures 30, and a packaging layer 40.

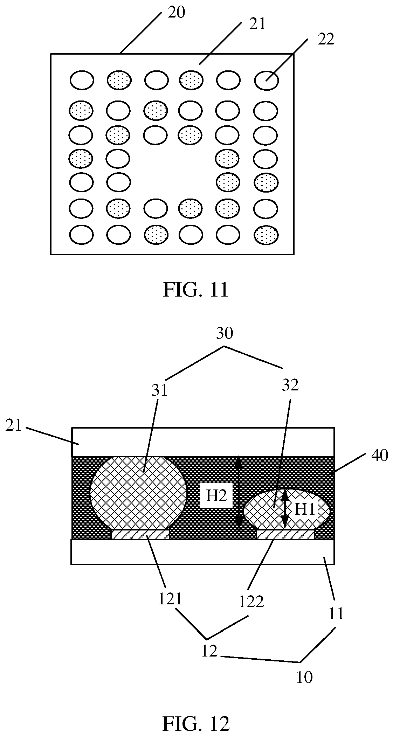

As shown in FIG. 10, there are a plurality of pads 12 on the circuit board 10. Specifically, the circuit board 10 includes a first substrate 11 and the plurality of pads 12 located on a surface of the first substrate 11. As shown in FIG. 12, the plurality of pads 12 include a plurality of first pads 121 and at least one second pad 122.

Still as shown in FIG. 12, the chip 20 is electrically connected to the first pad 121, and the second pad 122 is a redundant pad.

The plurality of electrical connection structures 30 include a plurality of first electrical connection structures 31 and at least one second electrical connection structure 32. The first electrical connection structure 31 is located on a surface of the first pad 121, and electrically connects the chip 20 and the first pad 121. The second electrical connection structure 32 is located on a surface of the second pad 122.

The packaging layer 40 fills a gap between the circuit board 10 and the chip 20.

It should be noted that the first electrical connection structure 31 is a solder joint for soldering the chip 20 and the circuit board 10.

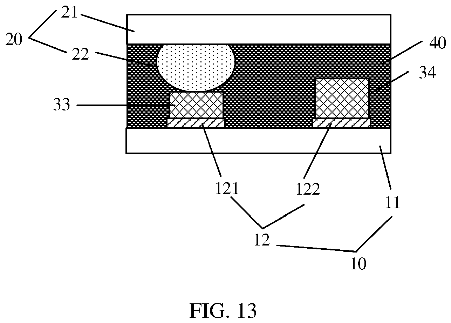

It should be further noted that before the plurality of electrical connection structures are formed, there are a plurality of solder balls 22 on the chip 20. Specifically, as shown in FIG. 11 and FIG. 13, the chip 20 includes a second substrate 21 and the plurality of solder balls 22 located on a surface of the second substrate 21. The first pad 121 is configured to be electrically connected to the solder ball 22 on the chip 20. The second pad 122 is a redundant pad. During specific manufacturing, still as shown in FIG. 13, solder paste is first formed on a surface of the pad 12 on the circuit board 10. Specifically, first solder paste 33 is formed on the surface of the first pad 121, and second solder paste 34 is formed on the surface of the second pad 122. Then, the chip 20 is placed on a side surface that is of the solder paste and that is far away from the circuit board 10, where the solder ball 22 on the chip 20 is located on a side that is of the first solder paste 33 and that is far away from the circuit board 10; and the solder paste is heated, so that the solder paste and the solder ball 22 on the chip 20 are melted to form the plurality of electrical connection structures 30, as shown in FIG. 12. In other words, in this embodiment, FIG. 13 is a schematic diagram of a structure of the chip structure that exists before the solder paste is melted, and FIG. 12 is a schematic diagram of a structure of the chip structure that exists after the solder paste is melted. Specifically, after the solder paste is melted, the first solder paste located on the surface of the first pad 121 and the solder ball are melted into an integrated structure to form a solder joint 31, and the second solder paste located on the surface of the second pad 122 becomes solder paste that exists after reflow.

In the chip structure provided in this embodiment of this application, the second pad is added to the circuit board, to increase pad density of the circuit board, so as to reduce a spacing between adjacent pads on the circuit board, and the second electrical connection structure is disposed on the second pad, to reduce a gap between the second pad and the chip. In this way, when glue is dispensed in the gap between the chip and the circuit board, capillary action between the adjacent pads on the circuit board is enhanced, to improve a glue filling effect between the chip and the circuit board, increase bonding force between the circuit board and the chip, reduce a probability that a glue filling void occurs, and resolve a problem that a solder joint dendrite occurs.

It should be noted that in this embodiment of this application, the chip includes a first region and a second region, and solder ball density in the first region is greater than that in the second region. Correspondingly, the circuit board includes a third region corresponding to the first region and a fourth region corresponding to the second region, and first pad density in the third region is greater than that in the fourth region.

It should be further noted that in this embodiment of this application, the second pad is located in the fourth region, and the second pad is added to the fourth region, to increase the pad density in the fourth region, so as to reduce a spacing between adjacent pads in the fourth region, and the second electrical connection structure is disposed on the second pad, to reduce the gap between the second pad and the chip. In this way, when glue is dispensed in the gap between the chip and the circuit board to form the packaging layer, capillary action between the adjacent pads in the fourth region is enhanced, to improve a glue filling effect in the fourth region, increase bonding force between the fourth region of the circuit board and the chip, reduce the probability that a glue filling void occurs, and resolve the problem that a solder joint dendrite occurs.

Based on any one of the foregoing embodiments, in an embodiment of this application, still as shown in FIG. 12, in a direction from the circuit board 10 to the chip 20, a ratio of a height H1 of the second electrical connection structure 32 to a distance H2 between the second pad 122 and the chip 20 ranges from 0.5 to 1 (inclusive). In this way, when glue is dispensed to fill the gap between the chip 20 and the circuit board 10 to form the packaging layer, there is relatively strong capillary action at a position at which the second pad 122 is located.

Optionally, in an embodiment of this application, in a direction from the circuit board 10 to the chip 20, the second electrical connection structure completely fills a distance between the second pad and the chip, to further enhance capillary action at a position of the second pad, improve the glue filling effect between the chip 20 and the circuit board 10, increase the bonding force between the chip 20 and the circuit board 10, reduce the probability that a glue filling void occurs, and resolve the problem that a dendrite occurs.

Based on any one of the foregoing embodiments, in an embodiment of this application, on a plane on which the circuit board is located, a size of a gap between adjacent pads in the plurality of pads is not greater than 400 microns. In this way, when glue is dispensed to fill the gap between the chip and the circuit board to form the packaging layer, there is relatively strong capillary action at a position at which each pad is located, to improve a glue filling effect of the gap between the chip and the circuit board.

Based on any one of the foregoing embodiments, in an embodiment of this application, the plurality of pads are evenly distributed on the circuit board, so that there is same or similar capillary action at positions at which all the pads are located. In this way, when glue is dispensed to fill the gap between the chip and the circuit board, there is a same or similar speed at which positions at which all the pads are located are wetted by the glue, to further reduce the probability that a glue filling void occurs.

It may be learned from the foregoing description that in the chip structure provided in this embodiment of this application, the second pad is added to the circuit board, to increase pad density of the circuit board, so as to reduce a spacing between adjacent pads on the circuit board, and the second electrical connection structure is disposed on the second pad, to reduce a gap between the second pad and the chip. In this way, when glue is dispensed in the gap between the chip and the circuit board to form the packaging layer, capillary action between the adjacent pads on the circuit board is enhanced, to improve a glue filling effect between the chip and the circuit board, increase bonding force between the circuit board and the chip, reduce a probability that a glue filling void occurs, and resolve a problem that a solder joint dendrite occurs.

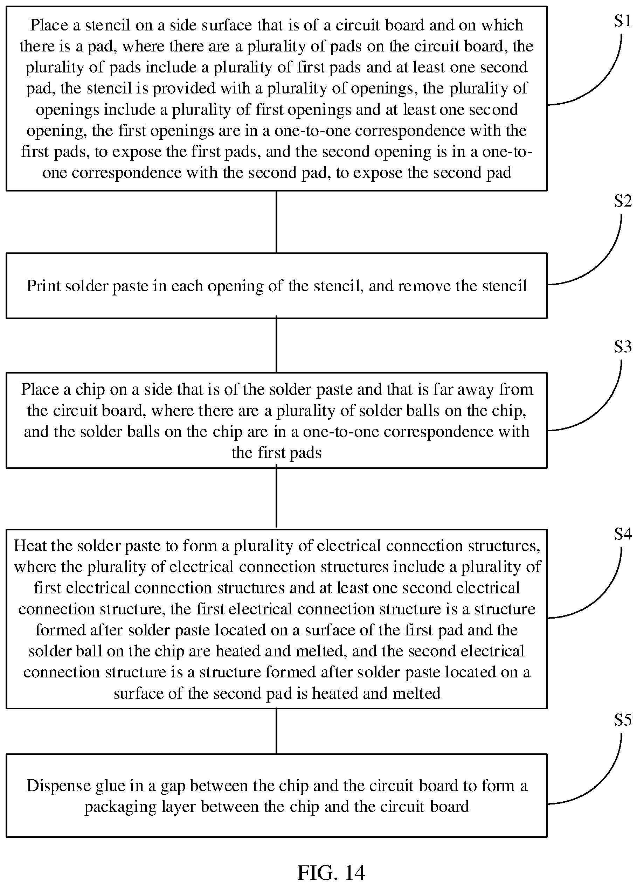

Correspondingly, an embodiment of this application further provides a method for manufacturing a chip structure. As shown in FIG. 14, the method includes the following steps.

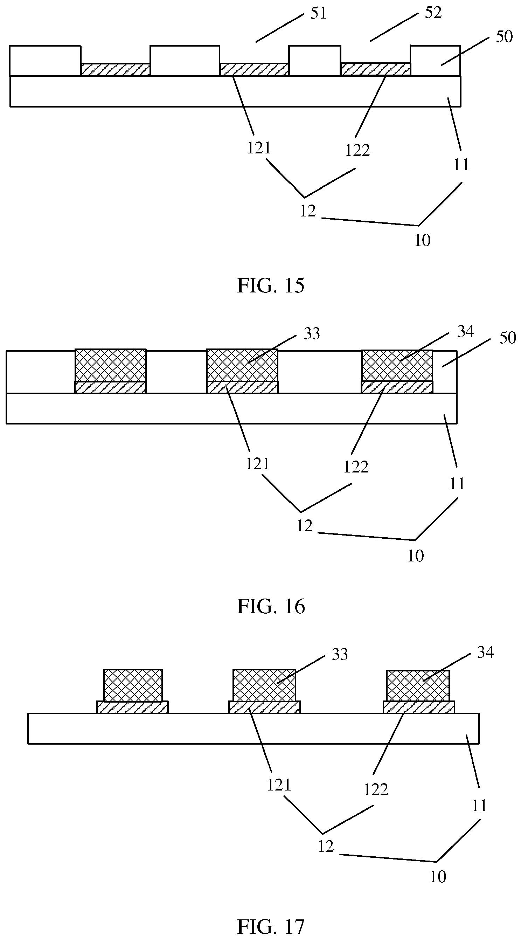

S 1: Place a stencil 50 on a side surface that is of a circuit board 10 and on which there is a pad 12, as shown in FIG. 15. There are a plurality of pads 12 on the circuit board 10. Specifically, the circuit board 10 includes a first substrate 11 and the plurality of pads 12 located on a surface of the first substrate 11. The plurality of pads 12 include a plurality of first pads 121 and at least one second pad 122. The stencil 50 is provided with a plurality of openings. The plurality of openings include a plurality of first openings 51 and at least one second opening 52. The first openings 51 are in a one-to-one correspondence with the first pads 121, to expose the first pads 121. The second opening 52 is in a one-to-one correspondence with the second pad 122, to expose the second pad 122.

S2: Print solder paste in each opening of the stencil 50, and remove the stencil 50, as shown in FIG. 16. Specifically, first solder paste 33 is printed in the first opening, and second solder paste 34 is printed in the second opening. As shown in FIG. 17, the first solder paste 33 and the second solder paste 34 are printed in a same process step.

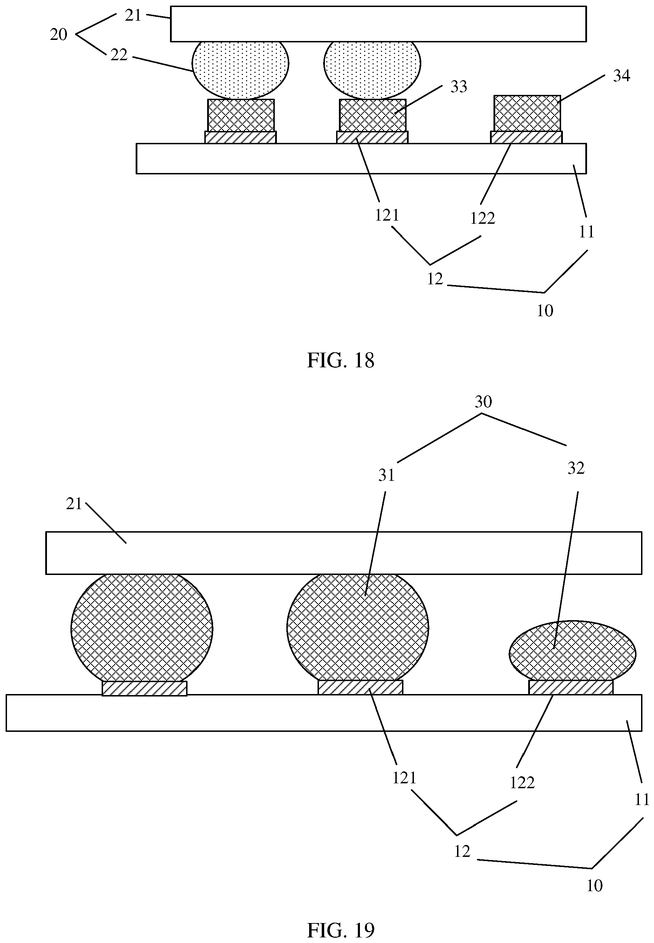

S3: Place a chip 20 on a side that is of the solder paste and that is far away from the circuit board 10, as shown in FIG. 18. There are a plurality of solder balls 22 on the chip 20. Specifically, the chip includes a second substrate 21 and the plurality of solder balls 22 located on a surface of the second substrate. The solder balls 22 on the chip 20 are in a one-to-one correspondence with the first pads 121. Specifically, the solder balls 22 on the chip 20 are located on a side surface that is of the first solder paste 33 and that is far away from the circuit board 10.

S4: Heat the solder paste to form a plurality of electrical connection structures 30, as shown in FIG. 19. The plurality of electrical connection structures 30 include a plurality of first electrical connection structures 31 and at least one second electrical connection structure 32. The first electrical connection structure 31 is a solder joint formed after the first solder paste located on a surface of the first pad 121 and the solder ball 22 on the chip 20 are heated and melted, and solders the circuit board 10 and the chip 20. The second electrical connection structure 32 is a structure formed after the second solder paste located on a surface of the second pad 122 is heated and melted.

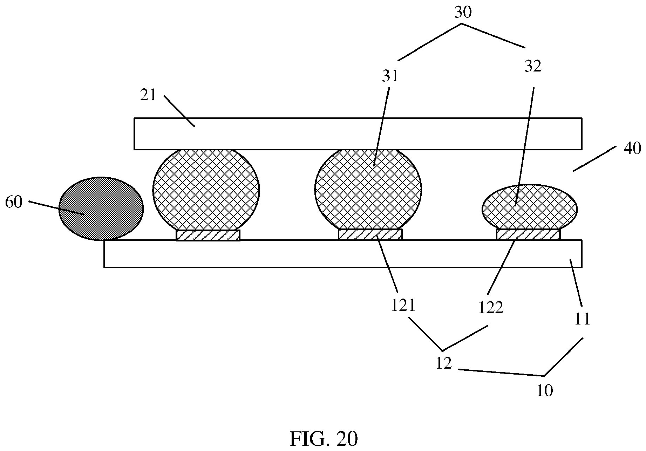

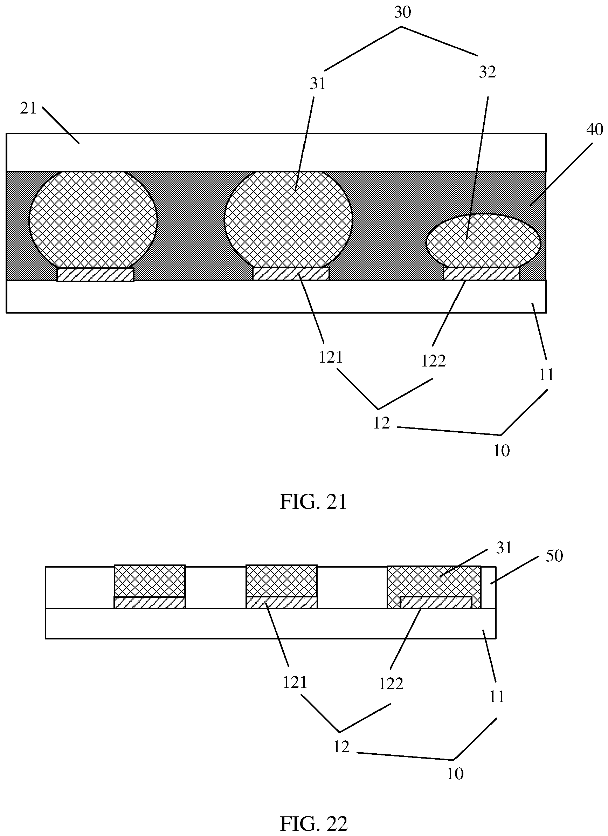

S5: Dispense glue 60 in a gap between the chip 20 and the circuit board 10, as shown in FIG. 20, to form a packaging layer 40 between the chip 20 and the circuit board 10, as shown in FIG. 21.

In the method for manufacturing a chip structure provided in this embodiment of this application, the second pad is added to the circuit board, to increase pad density of the circuit board, so as to reduce a spacing between adjacent pads on the circuit board, and the second electrical connection structure is disposed on the second pad, to reduce a gap between the second pad and the chip. In this way, when glue is dispensed in the gap between the chip and the circuit board to form the packaging layer, capillary action between the adjacent pads on the circuit board is enhanced, to improve a glue filling effect between the chip and the circuit board, increase bonding force between the circuit board and the chip, reduce a probability that a glue filling void occurs, and resolve a problem that a solder joint dendrite occurs.

Optionally, based on the foregoing embodiment, in an embodiment of this application, as shown in FIG. 15 and FIG. 16, sizes of the first opening 51 and the second opening 52 are the same, so that in a direction from the circuit board 10 to the chip 20, a height of the first solder paste 33 located on the surface of the first pad 121 is the same as a height of the second solder paste 34 located on the surface of the second pad 122.

The solder paste has a specific retraction characteristic. Therefore, in another embodiment of this application, as shown in FIG. 22 and FIG. 12, a size of the second opening is greater than a size of the first opening, so that after the solder paste is melted, in a direction from the circuit board 10 to the chip 20, a ratio of a height H1 of the second electrical connection structure 32 to a distance H2 between the second pad 122 and the chip 20 ranges from 0.5 to 1 (inclusive). In this way, when glue is dispensed to fill the gap between the chip 20 and the circuit board 10 to form the packaging layer 40, there is relatively strong capillary action at a position at which the second pad 122 is located, to improve the glue filling effect between the chip 20 and the circuit board 10, increase the bonding force between the chip 20 and the circuit board 10, reduce the probability that a glue filling void occurs, and resolve the problem that a dendrite occurs.

Specifically, in an embodiment of this application, the second opening is 1-3 (inclusive) times a size of the first opening, so that the second solder paste located in the second opening is 1-3 times (inclusive) a size of the first solder paste located in the first opening, to ensure that a height of the second connection structure is not less than 1/2 of a distance between the second pad and the chip, and does not exceed a height of the gap between the second pad and the chip.

Optionally, in an embodiment of this application, the second opening is 3 times a size of the first opening, so that the second solder paste located in the second opening is 3 times a size of the first solder paste located in the first opening, to ensure that in a direction from the circuit board to the chip, the second electrical connection structure completely fills a distance between the second pad and the chip, to further enhance capillary action at a position of the second pad, improve the glue filling effect between the chip 20 and the circuit board 10, increase the bonding force between the chip 20 and the circuit board 10, reduce the probability that a glue filling void occurs, and resolve the problem that a dendrite occurs.

In addition, an embodiment of this application further provides an electronic device. The electronic device includes the chip structure provided in any one of the foregoing embodiments, to improve reliability of a solder joint between a chip and a circuit board in the chip structure. Specifically, in some embodiments, the electronic device may be a device such as a mobile phone, a tablet computer, a desktop computer, a laptop computer, a notebook computer, an ultra-mobile personal computer (Ultra-mobile Personal Computer, UMPC), a handheld computer, a netbook computer, a personal digital assistant (Personal Digital Assistant, PDA), a wearable electronic device, or a smart watch.

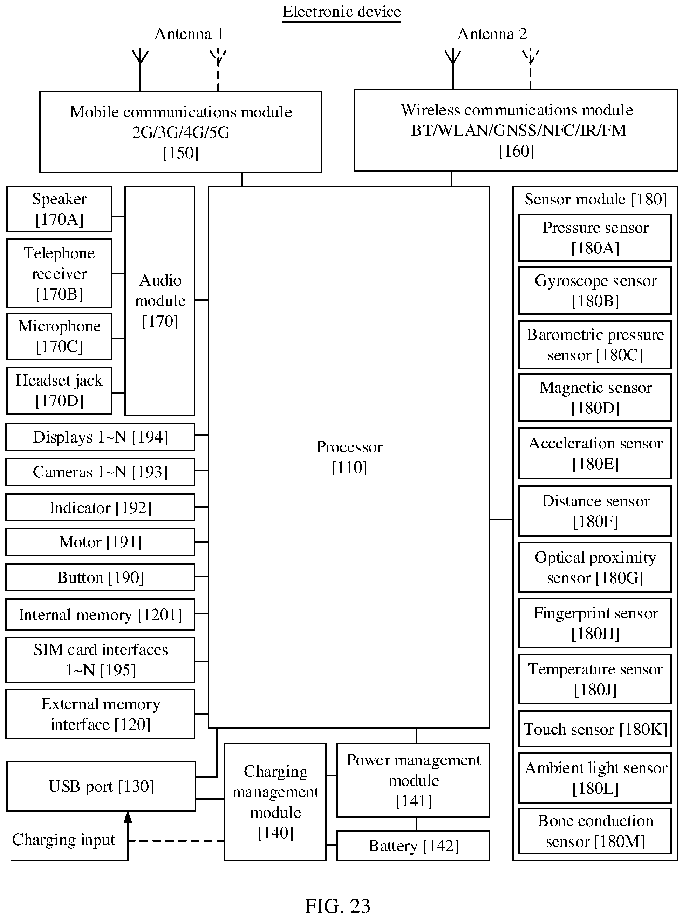

Optionally, in an embodiment of this application, as shown in FIG. 23, the electronic device may include a processor 110, an external memory interface 120, an internal memory 1201, a universal serial bus (universal serial bus, USB) port 130, a charging management module 140, a power management module 141, a battery 142, an antenna 1, an antenna 2, a mobile communications module 150, a wireless communications module 160, an audio module 170, a speaker 170A, a receiver 170B, a microphone 170C, a headset jack 170D, a sensor module 180, a button 190, a motor 191, an indicator 192, a camera 193, a display 194, a subscriber identification module (subscriber identification module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It should be noted that in this embodiment of this application, a filling hole is more likely to occur after a gap between a large-size chip such as the processor and the circuit board is packaged. Therefore, in an optional embodiment of this application, a chip structure that includes at least the processor and the circuit board soldered to the processor is the chip structure provided in any one of the foregoing embodiments of this application. However, this is not limited in this application. In another embodiment of this application, the chip structure provided in any of the foregoing embodiments may be used between any chip in the electronic device and a circuit board corresponding to the chip. This depends on a situation.

It may be understood that the structure shown in this embodiment constitutes no specific limitation on the electronic device. In some other embodiments, the electronic device may include more or fewer components than those shown in the figure, combine some components, split some components, or have different component arrangements. The component shown in the figure may be implemented by hardware, software, or a combination of software and hardware.

Optionally, in an embodiment of this application, a wireless communication function of the electronic device may be implemented by using the antenna 1, the antenna 2, the mobile communications module 150, the wireless communications module 160, a modem processor, a baseband processor, and the like.

The antenna 1 and the antenna 2 are configured to transmit and receive an electromagnetic wave signal. Each antenna in the electronic device may be configured to cover one or more communication bands. Different antennas may be multiplexed to improve antenna utilization. For example, the antenna 1 may be multiplexed into a diversity antenna in a wireless local area network. In some other embodiments, the antenna may be used in combination with a tuning switch.

The mobile communications module 150 may provide a solution to wireless communication such as 2G/3G/4G/5G applied to the electronic device. The mobile communications module 150 may include at least one filter, a switch, a power amplifier, a low noise amplifier (low noise amplifier, LNA), and the like. The mobile communications module 150 may receive an electromagnetic wave through the antenna 1, perform processing such as filtering and amplification on the received electromagnetic wave, and transfer a processed electromagnetic wave to the modem processor for demodulation. The mobile communications module 150 may further amplify a signal obtained after modulation by the modem processor, and convert the signal into an electromagnetic wave for radiation through the antenna 1. In some embodiments, at least some of functional modules in the mobile communications module 150 may be disposed in the processor 110. In some embodiments, at least some of functional modules in the mobile communications module 150 may be disposed in a same device as at least some of modules in the processor 110.

The modem processor may include a modulator and a demodulator. The modulator is configured to modulate a to-be-sent low-frequency baseband signal into a medium or high frequency signal. The demodulator is configured to demodulate a received electromagnetic wave signal into a low-frequency baseband signal. The demodulator then transfers the demodulated low-frequency baseband signal to the baseband processor for processing. The low-frequency baseband signal is processed by the baseband processor and then transferred to an application processor. The application processor outputs a sound signal by using an audio device (not limited to the speaker 170A or the receiver 170B), or displays an image or a video by using the display 194. In some embodiments, the modem processor may be an independent device. In some other embodiments, the modem processor may be independent of the processor 110, and is disposed in a same device as the mobile communications module 150 or another functional module.

The wireless communications module 160 may provide a solution to wireless communication such as a wireless local area network (wireless local area networks, WLAN) (for example, a wireless fidelity (wireless fidelity, Wi-Fi) network), bluetooth (bluetooth, BT), a global navigation satellite system (global navigation satellite system, GNSS), frequency modulation (frequency modulation, FM), near field communication (near field communication, NFC), or infrared (infrared, IR) applied to the electronic device. The wireless communications module 160 may be one or more devices into which at least one communication processing module is integrated. The wireless communications module 160 receives an electromagnetic wave through the antenna 2, modulates and filters an electromagnetic wave signal, and sends a processed signal to the processor 110. The wireless communications module 160 may further receive a to-be-sent signal from the processor 110, modulate and amplify the signal, and convert the signal into an electromagnetic wave for radiation through the antenna 2.

In some embodiments, in the electronic device, the antenna 1 is coupled to the mobile communications module 150, and the antenna 2 is coupled to the wireless communications module 160, so that the electronic device can communicate with a network and another device by using a wireless communications technology. The wireless communications technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, a GNSS, a WLAN, NFC, FM, an IR technology, and/or the like. The GNSS may include a global positioning system (global positioning system, GPS), a global navigation satellite system (global navigation satellite system, GLONASS), a beidou navigation satellite system (beidou navigation satellite system, BDS), a quasi-zenith satellite system (quasi-zenith satellite system, QZSS), and/or a satellite based augmentation system (satellite based augmentation systems, SBAS).

In the description of the foregoing implementations, a person skilled in the art may clearly understand that for convenient and brief description, division of the foregoing functional modules is merely used as an example for description. In actual application, the foregoing functions may be allocated to and completed by different functional modules based on a requirement, in other words, an inner structure of an apparatus is divided into different functional modules to implement all or some of the functions described above.

In the several embodiments provided in the embodiments, it should be understood that the disclosed system, apparatus, and method may be implemented in other manners. For example, the described apparatus embodiment is merely an example. For example, the module or unit division is merely logical function division and there may be another division manner in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, and may be located at one position, or may be distributed on a plurality of network units. Some or all of the units may be selected based on an actual requirement, to achieve the objectives of the solutions in the embodiments.

The foregoing description is merely specific implementations of this application, and is not intended to limit the protection scope of this application. Any variation or replacement made within the technical scope disclosed in this application shall fall within the protection scope of this application. Therefore, the protection scope of this application shall be subject to the protection scope of the claims.

## Claims

1. A chip structure, comprising:
a circuit board, wherein there are a plurality of pads on the circuit board, and the plurality of pads comprise a plurality of first pads and at least one second pad;
a chip, wherein the chip is electrically connected to the first pad, and the second pad is a redundant pad;
a plurality of electrical connection structures, wherein the plurality of electrical connection structures comprise a plurality of first electrical connection structures and at least one second electrical connection structure, the first electrical connection structure is located on a surface of the first pad, and electrically connects the chip and the first pad, and the second electrical connection structure is located on a surface of the second pad; and
a packaging layer, wherein the packaging layer fills a gap between the circuit board and the chip.

2. The chip structure according to claim 1, wherein in a direction from the circuit board to the chip, a ratio of a height of the second electrical connection structure to a distance between the second pad and the chip ranges from 0.5 to 1 (inclusive).

3. The chip structure according to claim 1, wherein on a plane on which the circuit board is located, a size of a gap between adjacent pads in the plurality of pads is not greater than 400 microns.

4. The chip structure according to claim 1, wherein the plurality of pads are evenly distributed on the circuit board.

5. A method for manufacturing a chip structure, comprising:
placing a stencil on a side surface that is of a circuit board and on which there is a pad, wherein there are a plurality of pads on the circuit board, the plurality of pads comprise a plurality of first pads and at least one second pad, the stencil is provided with a plurality of openings, the plurality of openings comprise a plurality of first openings and at least one second opening, the first openings are in a one-to-one correspondence with the first pads, to expose the first pads, and the second opening is in a one-to-one correspondence with the second pad, to expose the second pad;
printing solder paste in each opening of the stencil, and removing the stencil;
placing a chip on a side that is of the solder paste and that is far away from the circuit board, wherein there are a plurality of solder balls on the chip, and the solder balls on the chip are in a one-to-one correspondence with the first pads;
heating the solder paste to form a plurality of electrical connection structures, wherein the plurality of electrical connection structures comprise a plurality of first electrical connection structures and at least one second electrical connection structure, the first electrical connection structure is a structure formed after solder paste located on a surface of the first pad and the solder ball on the chip are heated and melted, and the second electrical connection structure is a structure formed after solder paste located on a surface of the second pad is heated and melted; and
dispensing glue in a gap between the chip and the circuit board to form a packaging layer between the chip and the circuit board.

6. The manufacturing method according to claim 5, wherein sizes of the first opening and the second opening are the same.

7. The manufacturing method according to claim 5, wherein a size of the second opening is greater than a size of the second opening.

8. The manufacturing method according to claim 5, wherein the second opening is 1-3 (inclusive) times a size of the first opening.

9. An electronic device, comprising the chip structure according to any one of claims 1 to 4.
